# NEUE EUROPÄISCHE PATENTSCHRIFT

(11) **EP 1 916 617 B2**
(45) Veröffentlichungstag und Bekanntmachung des Hinweises auf die Entscheidung über den Einspruch: **08.06.2011**
(45) Hinweis auf die Patenterteilung: 01.04.2009
(21) Anmeldenummer: 07017333.1
(22) Anmeldetag: 05.09.2007
(51) Int. Cl.: G06K 19/04

(54) **Optoelektronische Vorrichtung**
Optoelectronic device
Dispositif optoélectronique

(30) Priorität: 28.10.2006 DE 102006050937
(43) Veröffentlichungstag der Anmeldung: 30.04.2008
(73) Patentinhaber: Leuze electronic GmbH + Co. KG, 73277 Owen/Teck (DE)
(72) Erfinder: Moll, Georg, 72655 Altdorf (DE)
(74) Vertreter: Ruckh, Rainer Gerhard

(56) Entgegenhaltungen:
- EP-A2- 0 967 458
- DE-A1- 4 340 756
- DE-A1- 10 101 985
- DE-A1- 19 839 015
- DE-C1- 3 908 273
- US-A- 5 288 983
- US-A1- 2001 005 389
- US-A1- 2002 101 495
- US-A1- 2003 219 049

## Beschreibung

Die Erfindung betrifft ein Verfahren zum augensicheren Betreib einer optoelektronischen Abtastvorrichtung gemäß dem Obergriffdes Anspruchs 1.

Optoelektronische Vorrichtungen der in Rede stehenden Art bilden allgemein scannende optische Sensoren, welche jeweils einen Sendelichtstrahlen emittierenden Sender und einen Empfangslichtstrahlen empfangenden Empfänger aufweisten. Weiterhin ist eine Ablenkeinheit vorgesehen, mittels derer die Sendelichtstrahlen periodisch innerhalb eines Abtastbereichs geführt werden.

Aus der DE 101 01 985 A1 ist eine derartige, als Barcodelesegerät ausgebildete optoelektronische Vorrichtung bekannt. Mit diesem Barcodelesegerät werden innerhalb des Abtastbereichs liegende Barcodes detektiert. Zur Barcodedetektion wird dabei in der Auswerteeinheit der optoelektronischen Vorrichtung die Amplitudenmodulation der Empfangslichtstrahlen, die durch deren Reflexion an den Hell-Dunkel-Mustern der Barcodes entsteht, ausgewertet. Um insbesondere die hierzu erforderliche Auswertung der am Empfänger anstehenden Empfangssignale im Takt der Abtastperioden durchzuführen, wird während jeder Abtastperiode ein eindeutiges Synchronisadonssignal benötigt, anhand dessen der Anfang und das Ende einer Abtastperiode definiert werden kann.

Bei der optoelektronischen Vorrichtung gemäß der DE 101 01 985 A1 ist zur Generierung wenigstens eines Synchronisationssignals während jeder Abtastperiode in einer vorgegebenen Ablenkposition der über die Ablenkeinheit zum Austrittsfenster geführten Sendelichtstrahlen wenigstens ein Teil der vom Austrittsfenster zurückreflektierten Sendelichtstrahlen auf ein Empfangselement geführt, wobei das dadurch am Ausgang des Empfangselements generierte Empfangssignal das Synchronisationssignal bildet.

Optoelektronische Vorrichtungen der eingangs genannten Arten arbeiten insbesondere mit Sendern in Form von Laserdioden. Da das von diesen Laserdioden emittierte Sendelicht zu Schädigungen der Augen von in den Strahlengang der Sendelichtstrahlen blickenden Personen führen kann, ist es erforderlich, dass derartige optoelektronischen Vorrichtungen Überwachungseinrichtungen zur Gewährleistung der Augensicherheit aufweisen, die zu einem Abschalten des Senders führen, wenn eine mittlere Sendeleistung des Senders überschritten wird.

Diese Überwachungseinrichtungen umfassen typischerweise eine Überwachung der Ablenkeinheit derart, dass kontrolliert wird, dass die Drehzahl der Ablenkeinheit nicht unter eine gewisse Mindestdrehzahl sinkt. Dadurch wird vermieden, dass ein stehender Sendelichtstrahl dauernd auf das Auge einer Person gerichtet sein kann.

Weiterhin ist es zur Gewährleistung der Anforderungen um die Augensicherheit der optoelektronischen Vorrichtung notwendig, die vom Sender emittierte Strahlungsleistung zu überwachen.

Bei bekannten optoelektronischen Vorrichtungen, welche mit als Laserdioden ausgebildeten Sendern arbeiten, wird üblicherweise der Strom einer Monitordiode, die Bestandteil der Laserdiode ist, überwacht. Bei einer Laserdiode wird ein kleiner Bruchteil des emittierten Laserlichts auf die Monitordiode geführt, während der Großteil des Laserlichts als Sendelichtstrahlen in den Abtastbereich emittiert wird. Anhand des durch das auf die Monitordiode auftreffende Laserlichts generierten Monitordiodenstroms erfolgt die Kontrolle eines Regelkreises, mittels dessen der Betrieb der Laserdiode geregelt wird.

Bei bekannten optoelektronischen Vorrichtungen erfolgt die Überwachung der optischen Leistung der Laserdiode dadurch, dass der Monitordiodenstrom mit einem einmalig kalibrierten Sollwert verglichen wird. Ergibt sich eine unzulässige Abweichung vom Sollwert, wird die Laserdiode abgeschaltet, da dann keine korrekte Regelfunktion mehr vorliegt und somit ein augensicherer Betrieb der optoelektronischen Vorrichtung nicht mehr gewährleistet ist.

Diese Art der Überwachung der optischen Senderleistung ist jedoch prinzipiell fehlerbehaftet, da sich durch Temperatureinflüsse und Alterungseffekte das Verhältnis des von der Laserdiode in den Abtastbereich abgestrahlten und auf die Monitordiode geführten Laserlichts ändern kann. Derartige Fehler können durch eine Überwachung des Monitordiodenstroms prinzipiell nicht aufgedeckt werden. Auch können Fehler, die durch eine Alterung der Monitordiode bedingt sind, nicht aufgedeckt werden.

Prinzipiell könnte die Überwachung der vom Laser abgegebenen Leistung besser dadurch kontrolliert werden, dass der Laserdiodenstrom mit einer geeigneten Überwachungsschaltung kontrolliert wird. Dies ist jedoch äußerst aufwendig, da hierbei sowohl der Temperaturgang der Laserdiode als auch Kennlinienveränderungen des Laserdiodenstroms beherrscht und kontrolliert werden müssen.

Aus der US 2002/0101495 ist eine optoelektronische Vorrichtung bekannt, die einen Laser als Sender aufweist, wobei die vom Laser emittierten Lichtstrahlen über ein Polygonspiegelrad abgelenkt werden. Die Ausgangsleistung des Lasers wird durch Kontrollmittel überwacht, die einen separaten optischen Pfad umfassen, über welche ein Teil der Lichtstrahlen des Lasers ausgekoppelt und auf eine Photodiode geführt wird.

Aus der US 5,288,983 ist ein Barcodelesegerät bekannt, bei welchem von einem Sender emittierte Lichtstrahlen über einen Scanner abgelenkt werden. Mittels dreier Photodioden wird die Scanrichtung der über den Scanner geführten Lichtstrahlen erfasst. Die Ansprüche sind gegen dieses Dokument abgegrenzt.

Die DE 198 39 015 A1 betrifft eine scannende optoelektronische Vorrichtung, bei welcher ein Teil der von einem Sender emittierten Lichtstrahlen zu Kontrollzwecken auf einen Lichtempfänger geführt wird.

Der Erfindung liegt die Aufgabe zugrunde, ein Verfahren bereitzustellen, bei welchem mit möglichst geringem Aufwand eine sichere Kontrolle der Augensicherheit einer optoelektronischen Vorrichtung ermöglicht wird.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Das erfindungsgemäße Verfahren dient zur Erfassung von Gegenständen innerhalb eines Abtastbereichs mittels einer optoelektronischen Vorrichtung, die einen Sendelichtstrahlen emittierenden Sender, einen Empfangslichtstrahlen empfangenden Empfänger und eine Ablenkeinheit, mittels derer die Sendelichtstrahlen periodisch innerhalb des Abtastbereichs geführt werden, umfasst. Während jeder Abtastperiode werden bei einer vorgegebenen Ablenkposition der Ablenkeinheit die Sendelichtstrahlen zur Generierung eines Testempfangssignals auf ein Empfangselement oder über ein lichtreflektierendes Element zum Empfänger geführt. Durch Auswertung des Testempfangssignals wird die optische Ausgangsleistung des Senders bestimmt. Mittels einer Überwachungseinheit wird die Einhaltung einer Mindestdrehzahl der Ablenkeinheit kontrolliert. Durch die Kombination der Drehzahlüberwachung der Ablenkeinheit und der Überwachung der Ausgangsleistung erfolgt eine Überwachung der Augensicherheit.

Der Grundgedanke der Erfindung besteht darin, dass zur Überwachung des Senders mit dem Empfangselement oder dem lichtreflektierenden Element und dem diesem nachgeordneten Empfänger Komponenten der optoelektronischen Vorrichtung verwendet werden, die vom Sender und dem Regelkreis zu dessen Betrieb verschieden sind. Dies bedeutet, dass die Komponenten zur Überwachung der optischen Leistung des Senders einen von diesem Sender unabhängigen Pfad bilden, wodurch eine einfehlersichere Überwachung der Leistung des Senders erzielt wird. Damit können generell Fehler im Regelkreis des Senders aufgedeckt werden. Für den Fall, dass der Sender von einer Laserdiode mit integrierter Monitordiode gebildet ist, können auch Fehler durch Alterung der Monitordiode und auch Fehler, die durch eine Änderung des Verhältnisses der von der Laserdiode als Sendelichtstrahlen abgestrahltem Laserlicht und dem zur Monitordiode geführten Laserlicht bedingt sind, aufgedeckt werden.

Erfindungsgemäß wird die erfindungsgemäße Überwachung der Leistung des Senders mit einer Drehzahlüberwachung der Ablenkeinheit kombiniert. Dabei erfolgt ein Abschalten des Senders, wenn die Leistung des Senders von einem Sollwert unzulässig abweicht oder wenn die Drehzahl der Ablenkeinheit einen Mindestwert unterschreitet. Durch diese kombinierten Überwachungen wird die Augensicherheit der optoelektronischen Vorrichtung gewährleistet.

Erfindungsgemäß bildet das Empfangselement oder das lichtreflektierende Element eine Markierung, die zur Generierung eines Markierungsempfangssignals zur Synchronisation der periodischen Abtastungen der optoelektronischen Vorrichtung genutzt werden. Das Markierungsempfangssignal wird dabei vorteilhaft nicht nur zur Generierung eines Synchronisationssignals sondern gleichzeitig auch zur Generierung des Testempfangssignals genutzt.

Durch diese Doppelnutzung der Markierung kann die Überwachung der Ausgangsleistung des Senders nahezu ohne zusätzliche Komponenten durchgeführt werden, wodurch der konstruktive Aufwand zur Durchführung dieser Überwachung äußerst gering gehalten werden kann.

Die Erfindung wird im Nachstehenden anhand der Zeichnungen erläutert. Es zeigen:
- Figur 1:: Schematische Darstellung eines Ausführungsbeispiels einer optoelektronischen Vorrichtung.
- Figur 2:: Zeitlicher Verlauf des Empfangssignals eines Empfangselements der optoelektronischen Vorrichtung gemäß Figur 1 und eines daraus abgeleiteten Markierungssignals.

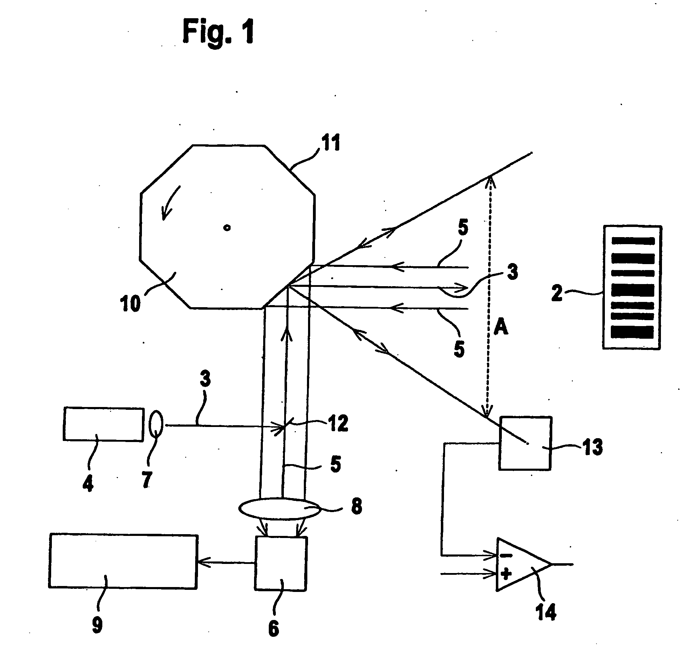

Figur 1 zeigt ein Ausführungsbeispiel einer optoelektronischen Vorrichtung 1 zum Erfassen von Gegenständen innerhalb eines Abtastbereichs A.

Prinzipiell kann die optoelektronische Vorrichtung 1 als Distanzmessvorrichtung oder dergleichen ausgebildet sein. Im vorliegenden Ausführungsbeispiel ist die optoelektronische Vorrichtung 1 als Barcodelesegerät ausgebildet, welches zum Erfassen von definierten Kontrastmustern aufweisenden Marken dient.

Im vorliegenden Ausführungsbeispiel sind die Marken von Barcodes 2 gebildet, welche eine Folge von hellen und dunklen Linienelementen aufweisen. Vorzugsweise bestehen die Barcodes 2 aus einer Folge von schwarzen und weißen Linienelementen.

Die Barcodes 2 werden innerhalb eines Abtastbereichs A von der optoelektronischen Vorrichtung periodisch abgetastet.

Hierzu weist die optoelektronische Vorrichtung 1 einen Sendelichtstrahlen 3 emittierenden Sender 4 und einen Empfangslichtstrahlen 5 empfangenden Empfänger 6 auf.

Der Sender 4 ist von einer Laserdiode gebildet, der Empfänger 6 besteht aus einer Fotodiode oder dergleichen. Zum Betrieb der Laserdiode ist eine nicht dargestellte Regelungsschaltung vorgesehen. Zur Regelung wird der Monitordiodenstrom einer in der Laserdiode integrierten, nicht dargestellten Monitordiode genutzt.

Zur Strahlformung der Sendelichtstrahlen 3 ist dem Sender 4 eine Sendeoptik 7 nachgeordnet. Dem Empfänger 6 ist eine Empfangsoptik 8 vorgeordnet, mittels derer die Empfangslichtstrahlen 5 auf den Empfänger 6 fokussiert werden.

Der Empfänger 6 ist an eine Auswerteeinheit 9 angeschlossen. Die Auswerteeinheit 9 ist von einem Mikrocontroller oder dergleichen gebildet.

Zur Erfassung der Barcodes 2 werden die Sendelichtstrahlen 3 periodisch innerhalb des Abtastbereichs geführt. Hierzu ist eine Ablenkeinheit vorgesehen, über welche sowohl die Sendelichtstrahlen 3 als auch die Empfangslichtstrahlen 5 geführt sind.

Die Ablenkeinheit ist im vorliegenden Ausführungsbeispiel von einem motorisch getriebenen, rotierenden Polygonspiegelrad 10 gebildet. Das Polygonspiegelrad 10 weist mehrere identische Spiegelflächen 11 auf, wobei im vorliegenden Beispiel acht derartiger Spiegelflächen 11 vorgesehen sind.

Die Sende- 3 und Empfangslichtstrahlen 5 werden jeweils über dieselbe Spiegelfläche 11 des Polygonspiegelrads 10 geführt. Dabei verlaufen die Strahlachsen der auf das Polygonspiegelrad 10 auftreffenden Sendelichtstrahlen 3 und die am Polygonspiegelrad 10 reflektierten Empfangslichtstrahlen 5 koaxial zueinander. Die koaxiale Strahlführung der Sende- 3 und Empfangslichtstrahlen 5 in diesem Bereich wird beispielsweise mittels eines Strahlteilers 12, der wie in Figur 1 dargestellt die Sendelichtstrahlen 3 ablenkt, erreicht. Die Empfangslichtstrahlen 5, die am Polygonspiegelrad 10 reflektiert werden, werden am Strahlteiler 12 vorbei zum Empfänger 6 geführt.

Durch die Drehbewegung des Polygonspiegelrads 10 werden die Sendelichtstrahlen 3 periodisch innerhalb eines Winkelbereichs abgelenkt, welcher den Abtastbereich A bildet. Die Größe des Winkelbereichs ist durch die Anzahl der Spiegelflächen 11 des Polygonspiegelrads 10 vorgegeben.

Mit den Sendelichtstrahlen 3 wird ein im Abtastbereich angeordneter Barcode 2 periodisch abgetastet. Die am Barcode 2 reflektierten Empfangslichtstrahlen 5 weisen entsprechend dem Muster der Linienelemente des Barcodes 2 eine Amplitudenmodulation auf. Dementsprechend weisen auch die Empfangssignale am Ausgang des Empfängers 6 anstehenden, durch die Empfangslichtstrahlen 5 generierten Empfangssignale eine entsprechende Amplitudenmodulation auf. Diese Amplitudenmodulation der Empfangssignale wird in der Auswerteeinheit 9 zur Dekodierung des jeweiligen Barcodes 2 ausgewertet.

Dabei werden in der Auswerteeinheit 9 jeweils die während einer Abtastperiode registrierten Empfangssignale zusammen ausgewertet.

Damit die während der Abtastung des Barcodes 2 registrierten Empfangssignale eindeutig den einzelnen Abtastperioden zugeordnet werden können, ist ein Synchronisationssignal erforderlich.

Dieses Synchronisationssignal wird während jeder Abtastperiode in jeweils derselben Winkelstellung der Spiegelfläche 11, über welche die Sendelichtstrahlen 3 während der jeweiligen Abtastperiode geführt sind, generiert. Anhand dieses Synchronisationssignals ist feststellbar, wann eine Abtastperiode beginnt, bzw. wann diese Abtastperiode endet. Daher wird das Synchronisationssignal typischerweise als "End of Scan"-(EOS)-Signal bezeichnet. Dabei muss das EOS-Signal jedoch nicht zwingend exakt am Ende einer Abtastperiode generiert werden. Vielmehr kann das EOS-Signal an einer beliebigen Abtastposition generiert werden. Dabei muss jedoch gewährleistet sein, dass die Abtastposition über die einzelnen Abtastperioden konstant bleibt.

Zur Generierung des Synchronisationssignals ist ein eine Markierung bildendes Empfangselement 13 vorgesehen, welches im vorliegenden Ausführungsbeispiel von einem Fotoelement gebildet ist.

Anstelle des Empfangselements 13 kann dort ein lichtreflektierendes Element vorgesehen sein, welches einen vorgegebenen Anteil der Sendelichtstrahlen 3 zum Empfänger 6 reflektiert.

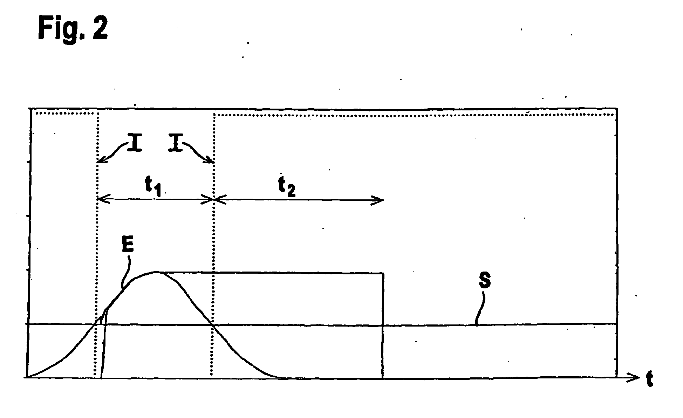

Da das Empfangselement 13 an einem vorgegebenen Ort innerhalb des Abtastbereiches liegt, treffen die Sendelichtstrahlen 3 nur in einer vorgegebenen Winkelstellung der Ablenkeinheit einmal pro Abtastperiode auf das Empfangselement 13. Das dadurch generierte Markierungsempfangssignal am Ausgang des Empfangselements 13 ist in Figur 2 mit E bezeichnet. Zur Generierung eines binären Synchronisationssignals wird dieses Markierungsempfangssignal mit einem Schwellwert S bewertet, wie aus Figur 2 ersichtlich ist. Das binäre Synchronisationssignal ist in Figur 2 mit I bezeichnet. Zur Schwellwertbewertung ist ein Komparator 14 vorgesehen, der dem Empfangselement 13 zugeordnet ist, und welcher über nicht dargestellte Zuleitungen an die Auswerteeinheit 9 angeschlossen ist.

Das Markierungsempfangssignal des Empfangselements 13 wird nicht nur zur Generierung des Synchronisationssignals genutzt, sondern auch zur Überwachung der optischen Ausgangsleistung des Senders 4. Hierbei wird der Umstand ausgenutzt, dass die Höhe des Markierungsempfangssignals proportional zur optischen Leistung des Senders 4 ist, wobei hierin alle im Strahlengang der Sendelichtstrahlen 3 liegende optischen Elemente mit eingeschlossen sind. Da das Markierungsempfangssignal während jeder Abtastperiode generiert wird, erfolgt auch die Überwachung der Senderleistung zyklisch.

Als Maß für die optische Leistung des Senders 4 wird im vorliegenden Fall der Spitzenwert des Markierungsempfangssignals bestimmt. Hierzu ist ein nicht dargestellter Spitzenwertdetektor vorgesehen. Für den Fall, dass der Sender 4 CW-moduliertes Laserlicht emittiert, ist zusätzlich ein Gleichrichter mit einem Mittelwert bildenden Filter vorgesehen. Mit diesen Komponenten wird aus der Hüllkurve des modulierten Markierungsempfangssignals dessen Spitzenwert bestimmt. Dieser Spitzenwert bildet ein Testempfangssignal anhand dessen die Sendeleistung des Senders 4 überwacht wird.

Um eine möglichst genaue Bestimmung des Spitzenwerts des Markierungsempfangssignals zu gewährleisten, erfolgt die Messung dieses Spitzenwerts nur innerhalb eines kurzen Zeitintervalls t₁, das in Figur 2 schematisch dargestellt ist. Da die Lage des Empfangselements 13 bekannt ist, kann bei bekannter Drehzahl der Ablenkeinheit dieses Zeitintervalls t₁ exakt so vorgegeben werden, dass der Spitzenwert mit Sicherheit in dieses Zeitintervall t₁ fällt. Der Spitzenwert wird dann für ein an das Zeitintervall t₁ anschließendes Zeitintervall t₂ erhalten und kann dann in die Auswerteeinheit 9 ausgelesen und ausgewertet werden.

Zur Gewährleistung und Überwachung der Augensicherheit der optoelektronischen Vorrichtung 1 wird neben der Leistungsüberwachung des Senders 4 mit einer nicht dargestellten Überwachungseinheit zudem überwacht, ob die Drehzahl der Ablenkeinheit oberhalb einer Mindestdrehzahl liegt.

Die Überwachung der Mindestdrehzahl kann beispielsweise über ein Tachosignal des Antriebs der Ablenkeinheit oder über ein im Strahlengang der Sendelichtstrahlen 3 angeordnetes Element erfolgen, das ein Signal für jede Abtastperiode erzeugt.

Wird dann eine unzulässige Abweichung der aktuell registrierten optischen Ausgangsleistung des Senders 4 oder ein Absinken der Drehzahl der Ablenkeinheit unter die Mindestdrehzahl registriert, erfolgt ein Abschalten des Senders 3.

### Bezugszeichenliste

- (1): Optoelektronische Vorrichtung
- (2): Barcode
- (3): Sendelichtstrahlen
- (4): Sender
- (5): Empfangslichtstrahlen
- (6): Empfänger
- (7): Sendeoptik
- (8): Empfangsoptik
- (9): Auswerteeinheit
- (10): Polygonspiegelrad
- (11): Spiegelfläche
- (12): Strahlteiler
- (13): Empfangselement
- (14): Komparator

## Patentansprüche

1. Verfahren zum augensicheren Betrieb einer optoelektronischen Abtastvorrichtung, welche einen Sendelichtstrahlen (3) emittierenden Sender (4), einen Empfangslichtstrahlen (5) empfangenden Empfänger (6) und eine Ablenkeinheit (10), mittels derer die Sendelichtstrahlen periodisch innerhalb des Abtastbereichs geführt werden, umfasst, wobei während jeder Abtastperiode bei einer vorgegebenen Ablenkposition der Ablenkeinheit die Sendelichtstrahlen zur Generierung eines Testempfangssignals auf ein Empfangselement (13) oder über ein lichtreflektierendes Element zum Empfänger geführt werden und durch Auswertung des Testempfangssignals die optische Ausgangsleistung des Senders bestimmt wird, **dadurch gekennzeichnet, dass** mittels einer Überwachungseinheit die Einhaltung einer Mindestdrehzahl der Ablenkeinheit kontrolliert wird, und dass durch die Kombination der Drehzahlüberwachung der Ablenkeinheit und der Überwachung der Ausgangsleistung eine Überwachung der Augensicherheit erfolgt und der Sender (3) abgeschaltet wird, falls die zulässigen Werte überschritten werden, und **dass** das Empfangselement (13) oder das lichtreflektierende Element eine Markierung bilden, mittels derer eine Synchronisation der periodischen Abtastungen erfolgt.

2. Verfahren nach Anspruch 1, **dadurch gekennzeichnet, dass** mittels der Markierung ein Markierungsempfangssignal generiert wird, aus welchem ein Synchronisationssignal und das Testempfangssignal abgeleitet werden.

3. Verfahren nach Anspruch 2, **dadurch gekennzeichnet, dass** zur Generierung des Testempfangssignals der Spitzenwert des Markierungsempfangssignals bestimmt wird.

4. Verfahren nach Anspruch 3, **dadurch gekennzeichnet, dass** die Spitzenwertbestimmung des Markierungsempfangssignals innerhalb eines Zeitintervalls t₁ erfolgt, dessen Anfangs- und Endpunkt durch die Drehzahl und/oder die Drehposition der Ablenkeinheit bestimmt ist.

5. Verfahren nach Anspruch 4, **dadurch gekennzeichnet, dass** der Spitzenwert des Markierungsempfangssignals zyklisch während jeder Abtastperiode bestimmt wird.

6. Verfahren nach einem der Ansprüche 1 bis 5, **dadurch gekennzeichnet, dass** der Sender (4) von einem Laser gebildet ist.

7. Verfahren nach einem der Ansprüche 1 bis 6, **dadurch gekennzeichnet, dass** die Ablenkeinheit einen rotierenden Spiegel oder ein rotierendes Prisma aufweist.

8. Verfahren nach einem der Ansprüche 1 bis 6, **dadurch gekennzeichnet, dass** die Ablenkeinheit von einem Polygonspiegelrad (10) gebildet ist.

9. Verfahren nach einem der Ansprüche 1 bis 8, **dadurch gekennzeichnet, dass** die optoelektronische Vorrichtung (1) ein Barcodelesegerät ist.

## Claims

1. Method for eyesight-safe operation of an optoelectronic scanning device, which comprises a transmitter (4) transmitting transmitted light beams (3), a receiver (6) receiving received light beams (5) and a deflecting unit (10) by means of which the transmitted light beams are periodically guided within the scanning region, wherein during each scanning period and with a predetermined deflecting position of the deflecting unit the transmitted light beams are, for generation of a test reception signal, guided onto a receiving element (13) or by way of a light reflecting element to the receiver and the optical output power of the transmitter is determined by evaluation of the test reception signal, **characterised in that** maintenance of a minimum rotational speed of the deflecting unit is controlled by means of a monitoring unit and that a monitoring of eyesight safety is carried out by the combination of the rotational speed monitoring of the deflecting unit and the monitoring of the output power and the transmitter (3) is switched off if the permissible values are exceeded and that the receiving element (13) or the light reflecting element forms a marking by means of which a synchronisation of the periodic scannings takes place.

2. Method according to claim 1, **characterised in that** by means of the marking a marking reception signal is generated from which a synchronisation signal and the test reception signal are derived.

3. Method according to claim 2, **characterised in that** for generation of the test reception signal the peak value of the marking reception signal is determined.

4. Method according to claim 3, **characterised in that** the peak value determination of the marking reception signal is carried out within a time interval t₁, the start and end points of which are determined by the rotational speed and/or the rotational position of the deflecting unit.

5. Method according to claim 4, **characterised in that** the peak value of the marking reception signal is cyclically determined during each scanning period.

6. Method according to any one of claims 1 to 5, **characterised in that** the transmitter (4) is formed by a laser.

7. Method according to any one of claims 1 to 6, **characterised in that** the deflecting unit comprises a rotating mirror or a rotating prism.

8. Method according to any one of claims 1 to 6, **characterised in** the deflecting unit is formed by a polygon mirror wheel (10).

9. Method according to any one of claims 1 to 8, **characterised in that** the optoelectronic device (1) is a barcode reader.

## Revendications

1. Procédé de fonctionnement sans danger pour les yeux d'un dispositif de balayage optoélectronique, lequel comprend un émetteur (4) émettant des rayons lumineux d'émission (3), un récepteur (6) recevant des rayons lumineux de réception (5) et une unité de déviation (10) au moyen de laquelle les rayons lumineux d'émission sont périodiquement guidés dans la zone de balayage, les rayons lumineux d'émission étant, pendant chaque période de balayage, à une position de balayage prédéfinie de l'unité de déviation, guidés sur un élément de réception (13) ou par l'intermédiaire d'un élément réflecteur de lumière vers le récepteur pour générer un signal de réception test et la puissance de sortie optique de l'émetteur étant déterminée par évaluation du signal de réception test, **caractérisé en ce que** le respect d'une vitesse de rotation minimale de l'unité de déviation est contrôlé au moyen d'une unité de surveillance et qu'une surveillance de la sécurité pour les yeux est réalisée par la combinaison de la surveillance de vitesse de rotation de l'unité de déviation et de la surveillance de la puissance de sortie, et l'émetteur (3) est coupé si les valeurs admissibles sont dépassées et **en ce que** l'élément de réception (13) ou l'élément réflecteur de lumière forme un marquage au moyen duquel une synchronisation des balayages périodiques est réalisée.

2. Procédé selon la revendication 1, **caractérisé en ce qu'**au moyen du marquage est généré un signal de réception de marquage duquel un signal de synchronisation et le signal de réception test sont dérivés.

3. Procédé selon la revendication 2, **caractérisé en ce que** pour générer le signal de réception test, on détermine la valeur maximale du signal de réception de marquage.

4. Procédé selon la revendication 3, **caractérisé en ce que** la valeur maximale du signal de réception de marquage est déterminée à l'intérieur d'un intervalle de temps t₁ dont les
points initial et final sont déterminés par la vitesse de rotation et/ou la position de rotation de l'unité de déviation.

5. Procédé selon la revendication 4, **caractérisé en ce que** la valeur maximale du signal de réception de marquage est déterminée cycliquement pendant chaque période de balayage.

6. Procédé selon l'une des revendications 1 à 5, **caractérisé en ce que** l'émetteur (4) est formé par un laser.

7. Procédé selon l'une des revendications 1 à 6, **caractérisé en ce que** l'unité de déviation présente un miroir tournant ou un prisme tournant.

8. Procédé selon l'une des revendications 1 à 6, **caractérisé en ce que** l'unité de déviation est formée par une roue à miroir polygonal (10).

9. Procédé selon l'une des revendications 1 à 8, **caractérisé en ce que** le dispositif optoélectronique (1) est un lecteur de codes à barres.
